# FASCICULE DE BREVET EUROPEEN

(11) **EP 4 473 553 B1**
(45) Date de publication et mention de la délivrance du brevet: **17.12.2025**
(21) Numéro de dépôt: 22836231.5
(22) Date de dépôt: 19.12.2022
(51) Int. Cl.: H01L 21/18, H01L 21/762

(54) **PROCEDE DE TRANSFERT D'UNE COUCHE MINCE SUR UN SUBSTRAT SUPPORT**
VERFAHREN ZUM ÜBERTRAGEN EINER DÜNNEN SCHICHT AUF EIN TRÄGERSUBSTRAT
METHOD FOR TRANSFERRING A THIN LAYER ONTO A SUPPORT SUBSTRATE

(30) Priorité: 31.01.2022 FR 2200842
(43) Date de publication de la demande: 11.12.2024
(73) Titulaire: SOITEC, 38190 Bernin (FR); Commissariat à l'Energie Atomique et aux Energies Alternatives, 75015 Paris (FR)
(72) Inventeur: LANDRU, Didier, 38190 BERNIN (FR); BEN MOHAMED, Nadia, 38190 BERNIN (FR); KONONCHUK, Oleg, 38190 BERNIN (FR); MAZEN, Frédéric, 38054 GRENOBLE CEDEX 9 (FR); GRAMPEIX, Helen, 38054 GRENOBLE CEDEX 9 (FR)
(74) Mandataire: IP Trust
(86) Numéro de dépôt international: PCT/EP2022/086726
(87) Numéro de publication internationale: WO 2023/143818

(56) Documents cités:
- US-A1- 2005 101 104
- US-B1- 6 540 827

## Description

### DOMAINE DE L'INVENTION

La présente invention vise le domaine de la microélectronique et des semi-conducteurs. En particulier, l'invention concerne un procédé de transfert d'une couche mince sur un substrat support, basé sur la technologie Smart Cut^{™}, la couche mince présentant une rugosité améliorée après séparation. Le procédé de transfert peut notamment être mis en œuvre pour la fabrication d'une structure SOI.

### ARRIÈRE PLAN TECHNOLOGIQUE DE L'INVENTION

La technologie Smart Cut^{™} est bien connue pour la fabrication de structures SOI (silicium sur isolant) et plus généralement, pour le transfert de couches minces. Cette technologie est basée sur la formation d'un plan fragile enterré dans un substrat donneur, par implantation d'espèces légères dans ledit substrat ; le plan fragile enterré délimite, avec une face avant du substrat donneur, la couche mince à transférer. Un assemblage intervient ensuite entre le substrat donneur et un substrat support, au niveau de leurs faces avant respectives, pour former une structure collée. L'assemblage est avantageusement réalisé par collage direct, par adhésion moléculaire, c'est-à-dire sans implication de matière adhésive : une interface de collage est ainsi établie entre les deux substrats assemblés. La croissance de microfissures dans le plan fragile enterré, par activation thermique, peut conduire à une séparation spontanée, le long dudit plan, donnant lieu au transfert de la couche mince sur le substrat support (formant la structure empilée, par exemple de type SOI). Le reste du substrat donneur peut être réutilisé pour un transfert de couche ultérieur. Après séparation, il est habituel d'appliquer des traitements de finition à la structure empilée, pour restaurer la qualité cristalline et la rugosité de surface de la couche mince transférée. Ces traitements, connus, peuvent notamment impliquer des traitements thermiques d'oxydation ou de lissage (sous atmosphères neutres ou réductrices), des nettoyages et/ou gravures chimiques et/ou des étapes de polissage mécano-chimiques. Différents outils d'inspection de la structure finale permettent de contrôler l'intégralité de la surface de la couche mince.

Lorsque la séparation dans le plan fragile enterré est spontanée, on observe des variabilités importantes en termes de rugosité de surface de la couche mince transférée, tant dans les hautes fréquences (microrugosité) que dans les basses fréquences (ondulations, zones locales de forte rugosité, marbrures, etc). Ces variabilités sont visibles et mesurables en particulier via les outils d'inspection précités, lors du contrôle de la couche mince dans la structure finale.

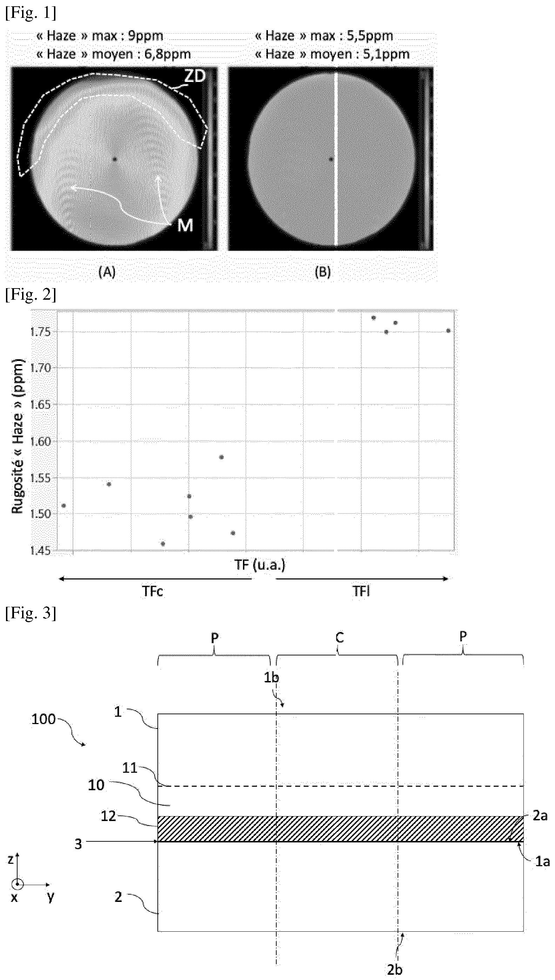

Rappelons que la rugosité de surface de la couche mince après finition peut être imagée par une cartographie obtenue à l'aide d'un outil d'inspection Surfscan^{™} de la société KLA-Tencor ([Fig.1]). Le niveau de rugosité ainsi que de potentiels motifs (marbrures, zones denses...) sont mesurés ou rendus apparents par la mesure de bruit de fond diffus (« haze » selon la terminologie anglo-saxonne communément employée) correspondant à l'intensité de la lumière diffusée par la surface de la couche mince. Le signal de « haze » varie linéairement avec le carré de la rugosité de surface RMS dans la gamme de fréquences spatiales de 0,1 à 10µm⁻¹. On pourra se référer à l'article « Seeing through the haze », de F. Holsteyns (Yield Management Solution, Spring 2004, pp50-54) pour une information plus complète sur cette technique d'inspection et d'évaluation de la rugosité sur une grande surface.

Les cartographies de la [Fig.1] montrent la rugosité de surface de deux couches minces transférées à partir de deux structures collées et traitées à l'identique jusqu'à la finition. Sur la cartographie (A), on observe une zone périphérique de rugosité résiduelle, dite « zone dense » (ZD) ; la cartographie (B) en est totalement dépourvue. Des marbrures (M) plus marquées sont également apparentes sur la cartographie (A). Les rugosités moyennes et maximales (exprimées en ppm de « haze ») sont en outre différentes entre les deux cartographies (A) et (B). La [Fig.1] illustre les variabilités de qualité et rugosité finales des couches minces, qui trouvent principalement leur origine dans les variabilités de rugosité de surface (hautes et basses fréquences) après séparation.

Les documents US6540827 B1 et US 2005/101104 Al décrivent des méthodes de détachement de couches cristallines à l'aide d'un recuit thermique comprenant un profil thermique spécifique.

Pour améliorer la qualité finale des couches minces transférées, il demeure donc toujours important de réduire la rugosité (quelle que soit la fréquence spatiale) de surface de ces couches après transfert, dans le cas d'une séparation spontanée par activation thermique.

### OBJET DE L'INVENTION

La présente invention propose un procédé de transfert mettant en œuvre un traitement thermique de fracture particulier, permettant l'obtention d'une rugosité de surface améliorée de la couche mince après séparation, pour atteindre une excellente qualité de surface après les étapes de finition de la structure empilée. Le procédé est en particulier avantageux pour la fabrication de structures SOI.

### BREVE DESCRIPTION DE L'INVENTION

La présente invention concerne un procédé de transfert d'une couche mince sur un substrat support, comprenant les étapes suivantes :
- la fourniture d'une structure collée comportant un substrat donneur et le substrat support, assemblés par collage direct au niveau de leurs faces avant respectives, suivant une interface de collage, le substrat donneur comprenant un plan fragile enterré,
- l'application d'un traitement thermique de fracture à la structure collée pour induire une séparation spontanée le long du plan fragile enterré, liée à une croissance de microfissures dans ledit plan par activation thermique, la séparation menant au transfert d'une couche mince issue du substrat donneur sur le substrat support.

Le procédé est remarquable en ce que le traitement thermique de fracture présente :
- une rampe de montée en température supérieure à 1°C/s, au moins entre une température initiale, inférieure à 250°C, et une température de palier, supérieure ou égale à 500°C, et
- un profil en température tel que la structure collée subisse un gradient de température variant entre 40°C et 120°C entre une région centrale et une région périphérique.

Selon des caractéristiques avantageuses de l'invention, prises seules ou selon toute combinaison réalisable :
- le procédé de transfert comprend avant le traitement thermique de fracture, un pré-recuit appliqué à la structure collée, de manière à réaliser un pré-murissement des microfissures dans le plan fragile enterré, le budget thermique apporté par le pré-recuit étant insuffisant pour provoquer une séparation spontanée ;
- le gradient de température est compris entre 40°C et 80°C ;
- le procédé de transfert comprend une étape de lissage d'une face avant de la couche mince, à la suite de la séparation, par application d'un recuit à une température supérieure à 1000°C, dans une atmosphère neutre ou réductrice, le traitement thermique de fracture et l'étape de lissage s'opérant dans une même enceinte et un même équipement ;
- le plan fragile enterré est formé dans le substrat donneur par implantation d'espèces légères telles que l'hydrogène, l'hélium ou une combinaison de ces deux espèces ;
- le substrat donneur et/ou le substrat support présentent une couche isolante, au moins du côté de leur face avant respective, qui forme une couche isolante enterrée, adjacente à l'interface de collage, dans la structure collée ;
- la couche mince, issue du substrat donneur, est en silicium monocristallin et le substrat support comprend du silicium monocristallin, pour former une structure empilée de type SOI.

### Brève description des dessins

D'autres caractéristiques et avantages de l'invention ressortiront de la description détaillée qui va suivre en référence aux figures annexées sur lesquelles :
[Fig.1] La [Fig.1] présente deux cartographies représentatives de la rugosité de surface de deux couches minces transférées, issues de deux structures collées traitées à l'identique jusqu'à la finition, selon un procédé classique ; les deux cartographies ont été obtenues via un outil d'inspection Surfscan^{™} ;
[Fig.2] La [Fig.2] présente un graphe indiquant la rugosité de surface des couches minces en fonction du temps de fracture, pour une pluralité de structures collées (d'un type différent des structures collées énoncées en référence à la [Fig.1]) traitées de manière identique jusqu'à la finition, selon un procédé classique ;
[Fig.3] La [Fig.3] présente une structure collée intervenant à une étape intermédiaire du procédé de transfert conforme à l'invention ;
[Fig.4] La [Fig.4] présente une structure empilée et le reste d'un substrat donneur, obtenus par un procédé de transfert conforme à l'invention ;
[Fig.5] La [Fig.5] présente un exemple de profil de température au cours d'un traitement thermique de fracture mis en œuvre dans un procédé de transfert conforme à l'invention ;
[Fig.6] La [Fig.6] présente deux cartographies représentatives de la rugosité de surface de deux couches minces transférées d'une première (à gauche) et d'une deuxième (à droite) structures SOI, la première ayant été obtenue avec un procédé de transfert classique et la deuxième avec un procédé de transfert conforme à l'invention ; les deux cartographies ont été obtenues via un outil d'inspection Surfscan^{™}.

Certaines figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y.

Les mêmes références sur les figures ou dans la description pourront être utilisées pour des éléments de même nature.

### DESCRIPTION DETAILLEE DE L'INVENTION

L'invention concerne un procédé de transfert d'une couche mince sur un substrat support, pour former une structure empilée. Comme évoqué en introduction, une telle structure empilée peut notamment être de type SOI, et comprendre une couche mince superficielle en silicium, une couche isolante intermédiaire et un substrat support en silicium. Le substrat support peut optionnellement comporter d'autres couches fonctionnelles, telle qu'une couche de piégeage de charges, par exemple pour des structures SOI destinées à des applications radiofréquences. Le procédé de transfert selon l'invention n'est néanmoins pas limité à la fabrication de SOI et peut être appliqué à nombre d'autres structures empilées dans le domaine de la microélectronique, des mi-crosystèmes et des semi-conducteurs.

Le procédé de transfert selon l'invention est basé sur la technologie Smart Cut^{™}. Lorsque la séparation dans le plan fragile enterré est spontanée, le temps de fracture (c'est-à-dire le temps au bout duquel la séparation intervient, lors du recuit thermique de fracture) peut différer entre une pluralité d'ensembles collés traités à l'identique, subissant le même recuit, dans le même four. Le temps de fracture (TF) dépend d'une multitude de paramètres liés à la formation du plan fragile enterré, au recuit de fracture, à la nature de la structure collée, etc. La demanderesse a remarqué que, pour des structures collées préparées de façon similaire et subissant un même recuit de fracture, les séparations qui interviennent en des temps de fracture courts (TFc) donnent lieu à des rugosités de surface hautes fréquences (microrugosité) de couches minces dans les structures empilées finales (c'est-à-dire après transfert et finition) plus faibles que les séparations intervenant en des temps de fracture plus longs (TFl), comme cela est visible sur la [Fig.2]. En outre, les temps de fracture longs induisent une zone locale de rugosité très élevée (appelée zone dense ZD) en bord de couche mince après fracture, ce qui est peu ou pas le cas lorsque le temps de fracture est court. Cette zone dense dégrade la qualité et la rugosité de la couche mince, même après finition, comme cela est visible sur la cartographie (A) de la [Fig.1].

Le procédé de transfert selon l'invention vise donc à amorcer de façon anticipée (temps de fracture court) et répétable (faible dispersion du temps de fracture entre une pluralité de structures collées similaires) la séparation spontanée dans le plan fragile enterré, de manière à améliorer substantiellement la rugosité de surface de la couche mince transférée.

Pour cela, le procédé de transfert comprend en premier lieu la fourniture d'une structure collée 100 comportant un substrat donneur 1 et le substrat support 2, assemblés par collage direct au niveau de leurs faces avant respectives (1a,2a), suivant une interface de collage 3 ([Fig.3]).

Le substrat donneur 1 se présente préférentiellement sous la forme d'une plaquette de diamètre 100mm, 150mm, 200mm, 300mm voire 450mm et d'épaisseur comprise typiquement entre 300µm et 1mm. Il comporte une face avant 1a et une face arrière 1b. La rugosité de surface de la face avant 1a est choisie inférieure à 1,0nm RMS, voire préférentiellement inférieure à 0,5nm RMS (mesurée par microscopie à force atomique (AFM), par exemple sur un scan de 20µm x 20µm). Le substrat donneur 1 peut être en silicium ou en tout autre matériau semi-conducteur ou isolant, pour lequel un transfert de couche mince peut présenter un intérêt (par exemple, SiC, GaN, etc).

Notons également que le substrat donneur 1 pourra comporter une ou plusieurs couches supplémentaires 12, au moins du côté de sa face avant 1a, par exemple une couche isolante. Comme illustré sur la [Fig.3], cette couche supplémentaire 12 devient une couche intermédiaire enterrée dans la structure collée 100, après assemblage du substrat donneur 1 et du substrat support 2.

Le substrat donneur 1 comprend un plan fragile enterré 11, qui délimite une couche mince 10 à transférer. Comme cela est bien connu en référence à la technologie Smart Cut^{™}, un tel plan fragile enterré 11 peut être formé par implantation d'espèces légères, telles que l'hydrogène, l'hélium ou une combinaison de ces deux espèces. Les espèces légères sont implantées à une profondeur déterminée dans le substrat donneur 1, cohérente avec l'épaisseur de la couche mince 10 visée. Ces espèces légères vont former, autour de la profondeur déterminée, des microcavités distribuées dans une fine couche sensiblement parallèle à la face avant 1a du substrat donneur 1, soit parallèle au plan (x,y) sur les figures. On appelle cette fine couche le plan fragile enterré 11, par souci de simplification.

L'énergie d'implantation des espèces légères est choisie de manière à atteindre la profondeur déterminée. Par exemple, des ions hydrogène seront implantés à une énergie comprise entre 10 keV et 210 keV, et à une dose comprise entre 5E16/cm² et 1E17/cm², pour délimiter une couche mince 10 présentant une épaisseur de l'ordre de 100 à 1500nm. Rappelons qu'une couche supplémentaire pourra être déposée sur la face avant 1a du substrat donneur 1, préalablement à l'étape d'implantation ionique. Cette couche supplémentaire peut être composée par un matériau tel que l'oxyde de silicium ou le nitrure de silicium par exemple. Elle peut être conservée pour l'étape suivante d'assemblage (et former tout ou partie de la couche intermédiaire de la structure collée 100), ou elle peut être retirée.

Le substrat support 2 se présente également préférentiellement sous la forme d'une plaquette de diamètre 100mm, 150mm, 200mm, 300mm voire 450mm et d'épaisseur comprise typiquement entre 300µm et 1mm. Il comporte une face avant 2a et une face arrière 2b. La rugosité de surface de la face avant 2a est choisie inférieure à 1,0nm RMS, voire préférentiellement inférieure à 0,5nm RMS (mesurée par AFM, par exemple sur un scan de 20µm x 20µm). Le substrat support 2 peut être en silicium ou en tout autre matériau semi-conducteur ou isolant, sur lequel un transfert de couche mince peut présenter un intérêt. Dans le cadre de la présente invention, le (ou les) matériau(x) composant le substrat support 2 devra(ont) être compatible(s) avec l'application de températures supérieures ou égales à 400°C à la structure collée 100 issue de l'assemblage du substrat donneur 1 et dudit substrat support 2.

On note également que le substrat support 1 peut comporter une ou plusieurs couches supplémentaires, au moins du côté de sa face avant 2a, par exemple une couche isolante et/ou une couche de piégeage de charges. Cette (ou ces) couche(s) supplémentaire(s) se retrouvent enterrées dans la structure collée 100, après assemblage du substrat donneur 1 et du substrat support 2.

L'assemblage entre les substrats donneur 1 et support 2 est basé sur un collage direct par adhésion moléculaire. Comme cela est bien connu en soi, un tel collage ne nécessite pas une matière adhésive, car des liaisons s'établissent à l'échelle atomique entre les surfaces assemblées, formant l'interface de collage 3. Plusieurs types de collage par adhésion moléculaire existent, qui diffèrent notamment par leurs conditions de température, de pression, d'atmosphère ou de traitements préalables à la mise en contact des surfaces. On peut citer le collage à température ambiante avec ou sans activation préalable par plasma des surfaces à assembler, le collage par diffusion atomique (« Atomic diffusion bonding » ou ADB selon la terminologie anglo-saxonne), le collage avec activation de surface (« Surface-activated bonding » ou SAB), etc.

L'étape d'assemblage peut comprendre, préalablement à la mise en contact des faces avant 1a,2a à assembler, des séquences classiques de nettoyages par voie chimique (par exemple, nettoyage RCA), d'activation de surface (par exemple, par plasma oxygène ou azote) ou autres préparations de surface (telles que le nettoyage par brossage (« scrubbing »)), susceptibles de favoriser la qualité de l'interface de collage 3 (faible défectivité, forte énergie d'adhésion).

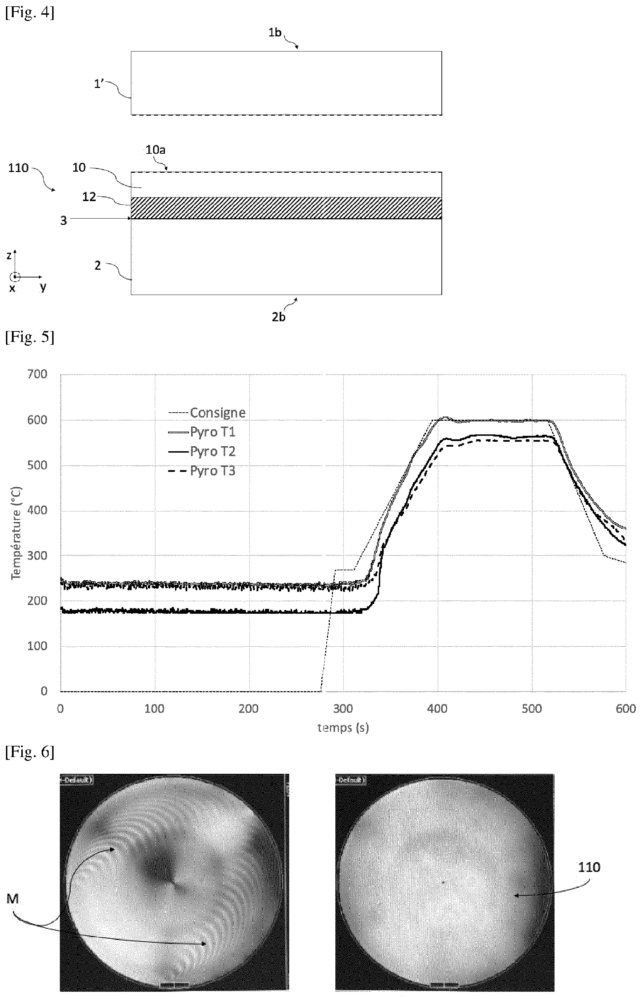

La structure collée 100 étant formée, le procédé de transfert selon l'invention prévoit de lui appliquer un traitement thermique de fracture pour induire une séparation spontanée le long du plan fragile enterré 11. La séparation mène au transfert de la couche mince 10 issue du substrat donneur 1 sur le substrat support 2, pour former la structure empilée 110 ([Fig.4]). On obtient par ailleurs le reste 1' du substrat donneur.

Le traitement thermique de fracture selon l'invention est particulier en ce qu'il présente une rampe de montée en température très rapide et un profil en température configuré pour surchauffer le centre de la structure collée 100 par rapport à sa périphérie.

En substance, la rampe de montée en température du traitement thermique de fracture est supérieure à 1°C/s, au moins entre une température initiale, inférieure à 250°C, et une température de palier, supérieure ou égale à 500°C.

Pour opérer des rampes de montée en température rapide, il est avantageux d'utiliser un équipement de recuit rapide, tel que des fours connus sous les dénominations RTA (« Rapid Thermal Anneal ») ou RTP (« Rapid thermal Process »), largement utilisés dans le domaine du semi-conducteur et de la microélectronique. Le chauffage dans ce type d'équipement s'effectue grâce à des lampes infra-rouge dont la puissance est réglable de manière à ajuster la température dans différentes zones en vis-à-vis de la structure traitée.

Dans un équipement RTA ou RTP, la température initiale, lorsque la structure collée 100 est introduite dans l'enceinte du four, est habituellement la température ambiante. La rampe de montée en température peut également être rapide, typiquement de l'ordre de 1°C/s jusqu'à environ 200°C - 250°C. Néanmoins, le murissement des microcavités et microfissures dans le plan fragile enterré 11 étant en général lent pour des températures inférieures à 250°C, la rampe de montée en température jusqu'à 250°C est peu critique.

Au moins à partir de 250°C, le procédé selon l'invention prévoit une rampe rapide (>1°C/s) jusqu'à la température de palier, cette dernière étant supérieure ou égale à 500°C. La température de palier est typiquement comprise entre 500°C et 600°C, en particulier dans le cas où le substrat donneur 1 est en silicium. Au-delà de 250°C, la cinétique de croissance des microfissures dans le plan fragile enterré 11 est significative.

Le traitement thermique de fracture est en outre défini de sorte que la structure collée 100 subisse un gradient de température variant entre 40°C et 120°C entre une région centrale C et une région périphérique P. Par région centrale C, on entend une région englobant le centre de la structure collée 100, dans le plan (x,y) parallèle à l'interface de collage 3 ([Fig.3]). Le rayon (dans le plan (x,y)) de la région centrale C est typiquement compris entre 1% et 50% du rayon de la structure collée 100. La région périphérique P est une région entourant la région centrale C et englobant les bords de la structure collée 100.

On notera qu'une rampe de montée en température rapide jusqu'à 250°C peut être avantageuse pour aider à établir et conserver le gradient thermique dans la séquence suivante du traitement thermique de fracture, entre 250°C et la température de palier.

Préférentiellement, le gradient thermique entre la région centrale C et la région périphérique P est compris entre 40°C et 80°C.

Un exemple de profil de température, vu par la structure collée 100 lors du traitement thermique de fracture, est donné en [Fig.5]. La température initiale est la température ambiante, la température de palier est 600°C, comme cela est indiqué par la courbe de consigne. Trois pyromètres de contrôle T1,T2,T3, situés sur différents points de la structure collée 100, permettent d'observer la montée en température et le gradient subi par ladite structure : le pyromètre T1 est positionné au centre, les pyromètres T2,T3 sont positionnés en périphérie (à 20 mm du bord de l'ensemble collé 100). Notons que les pyromètres de contrôle utilisés ne donnent des mesures fiables qu'à partir de 250°C-300°C. La chauffe est ajustée dans les différentes zones du four en vis-à-vis de la structure collée 100, de manière à établir un gradient de température d'environ 50°C entre la région centrale C (cf courbe de température du pyromètre T1) et la région périphérique P (cf courbes de température des pyromètres T2, T3).

Le gradient de température appliqué à la structure collée 100 induit une surchauffe locale, dans la région centrale C, lors du traitement thermique de fracture, qui mène à un murissement plus important des microfissures du plan fragile enterré 11 dans cette région, par rapport à la région périphérique P. La plus forte maturité des microfissures dans la région centrale C agit comme un initiateur de fracture, au cours de la rampe de montée en température rapide, à l'approche de la température de palier.

Cela apporte l'avantage d'une propagation de l'onde de séparation du centre vers les bords la structure collée 100, ce qui limite fortement l'amplitude des marbrures M ou autres ondes de fracture (rugosité et ondulations basses fréquences) à la surface de la couche mince 10 transférée. Un autre avantage vient du fait que la séparation apparaît de façon précoce, avec un temps de fracture plus court que le temps de fracture classique pour une structure collée similaire subissant un recuit de fracture conventionnel. Une fracture précoce assure une faible microrugosité (hautes fréquence spatiales) et peu ou pas de zones locales de forte rugosité (autrement appelées zones denses ZD).

L'amélioration de la rugosité apportée par la mise en œuvre du procédé de transfert selon l'invention est illustrée sur la [Fig.6]. La première cartographie montre la rugosité de surface d'une couche mince transférée dans une première structure SOI obtenue avec un procédé de transfert conventionnel (incluant une étape de finition) : on note la présence de marbrures et ondes de fracture sur la surface. La deuxième cartographie montre une deuxième structure SOI 110, obtenue avec un procédé de transfert conforme à l'invention (incluant une étape de finition). La structure SOI 110 est dépourvue de marbrures M ou autres zones denses ZD.

Le procédé de transfert selon l'invention permet en outre d'atteindre des cadences importantes de traitements thermiques de fracture, du fait de la très faible durée de ceux-ci.

Dans un mode avantageux de réalisation du procédé de transfert, un pré-recuit est appliqué à la structure collée 100, avant le traitement thermique de fracture, de manière à réaliser un pré-murissement des microcavités et microfissures dans le plan fragile enterré 11. Le budget thermique apporté par le pré-recuit reste néanmoins insuffisant pour provoquer une séparation spontanée. On visera typiquement un budget thermique pour ce pré-murissement compris entre 25% et 75% du budget thermique de fracture menant à une séparation spontanée. Dans le cas d'un substrat donneur en silicium, la température du pré-recuit est préférentiellement définie autour de 350°C.

Le pré-recuit peut être effectué dans un four classique, horizontal ou vertical, ou dans un four RTA ou RTP. Il est important que le pré-murissement s'opère de manière aussi homogène que possible au sein du plan fragile enterré 11, quelle que soit la région de la plaque (centrale ou périphérique).

Le pré-murissement des microfissures dans le plan fragile enterré 11 peut encore améliorer la rugosité de surface de la couche mince 10 après séparation en réduisant l'écart de maturité des microfissures qui sera présent au moment de la séparation initiée par le gradient thermique (appliqué lors du traitement thermique de fracture). En effet, il est indispensable, pour jouer le rôle d'initiateur de fracture, d'établir un gradient de température significatif entre la région centrale C et la région périphérique P ; or, un tel gradient peut induire des différences importantes de murissement des microfissures au cours de la rampe rapide de montée en température. Une trop faible maturité des microfissures dans le plan fragile enterré 11, dans la région périphérique, au moment de la propagation de l'onde de fracture, génère des défauts de type marbrures et n'est donc pas favorable. Ainsi, pour de très forts gradients thermiques appliqués dans la rampe de montée du traitement thermique de fracture (par exemple supérieurs à 50°C, voire supérieurs à 80°C), il est avantageux de réaliser le pré-recuit de murissement, qui va amener l'ensemble du plan fragile enterré 11 à un niveau de maturité compatible avec une propagation de fracture sans génération de marbrures.

Le procédé de transfert selon l'invention peut en outre comprendre une étape de lissage de la face avant 10a de la couche mince 10, à la suite de la séparation.

Une telle étape est opérée pour éliminer la rugosité de surface liée à la fracture dans le plan fragile enterré 11 et pour restaurer la qualité cristalline de la couche mince transférée. La structure empilée 110, obtenue après séparation, est habituellement retirée du four dans lequel le traitement thermique de fracture a été réalisé, pour être traitée thermiquement, chimiquement et/ou mécano-chimique dans une étape de finition classique.

Avantageusement, l'étape de lissage du procédé de transfert comprend ici l'application d'un recuit à une température supérieure à 1000°C, dans une atmosphère neutre ou réductrice, directement à la suite du traitement thermique de fracture, sans retirer la structure empilée 110 de l'enceinte du four où elle a subi ledit traitement de fracture, voire sans redescente à la température ambiante. La structure empilée 110 et le reste 1' du substrat donneur demeurant l'un contre l'autre, bien que séparés, on peut ainsi bénéficier d'une atmosphère « locale » parfaitement contrôlée en vis-à-vis des surfaces fracturées. Cette atmosphère locale est formée pour l'essentiel des gaz d'implantation et elle est parfaitement non oxydante : la surface de la couche mince 10 est en conséquence absolument libre de toute oxydation et peut se lisser de façon extrêmement efficace, c'est-à-dire à plus basses températures que des surfaces recouvertes même légèrement d'un oxyde natif.

L'étape de lissage s'opère ainsi préférentiellement dans la même enceinte et le même four que l'étape de séparation, en augmentant la température dans la gamme 1000°C - 1200°C. L'atmosphère dans l'enceinte du four est neutre ou réductrice (préférentiellement Ar, H2, Ar/H2).

On s'assurera pour cette étape (au contraire de l'étape de fracture) que la température subie par la structure empilée 110 est uniforme et homogène sur toute la surface, un gradient de température entre centre et bord étant à cette étape préjudiciable.

L'enchaînement *in situ* du traitement thermique de fracture et de l'étape de lissage dans la même enceinte de four, sans redescente en température et sans retour en atmosphère extérieure, est particulièrement avantageux car il assure une très faible contamination de la surface de la couche mince 10 transférée, une absence totale d'oxyde natif et par conséquent une très grande efficacité de lissage, qui bénéficie en outre d'une rugosité réduite après séparation du fait d'une amorce anticipée de fracture.

Les fours de type RTA ou RTP sont parfaitement adaptés à un tel enchaînement, qui requiert des capacités de rampes rapides (traitement thermique de fracture) et de montée à hautes températures (étape de lissage). Cet enchaînement d'étapes constitue un atout en termes de productivité.

### Exemple de mise en œuvre :

Le procédé de transfert peut notamment être mis en œuvre pour élaborer une structure FDSOI (SOI totalement déplété, ou « fully depeleted SOI » selon la terminologie anglo-saxonne), c'est-à-dire présentant une faible épaisseur de couche mince superficielle et une faible épaisseur de couche isolante enterrée.

Le substrat donneur 1 est une plaquette en silicium monocristallin de 300mm de diamètre, et comprend au niveau de sa face avant 1a, une couche isolante 12 en oxyde de silicium d'épaisseur 35nm. Le plan fragile enterré 11 est formé par co-implantation d'ions hélium et hydrogène à des énergies respectives de 35 keV et 25 keV, et à des doses respectives à 1^{e}16 /cm² et 1^{e}16/cm².

Le substrat support 2 est une plaquette en silicium monocristallin de diamètre 300mm.

Une préparation de surface classique (nettoyages, activation plasma) des deux substrats 1,2 est ensuite effectuée en vue d'un collage par adhésion moléculaire.

L'assemblage, basé sur la mise en contact direct entre les faces avant 1a,2a des substrats donneur1 et support 2, permet d'obtenir une structure collée 100.

La structure collée 100 est introduite dans un four RTP pour opérer le traitement thermique de fracture, suivant la séquence suivante :
1. Mise sous vide de l'enceinte
2. Remplissage d'azote N2: 20s
3. Rampe de montée en température de la température ambiante à 270°C : 15s
4. Stabilisation à 270°C: 20s
5. Rampe de montée en température de 270°C à 600°C :4°C/s
6. Recuit au palier 600°C: 120s
7. Descente en température (600°C à 300°C): 60sec
8. Descente en température (300°C à ambiante): 450sec.

Les zones de chauffe du four RTP sont ajustées de manière à appliquer un gradient de température d'environ 50°C entre le centre et la région périphérique P de la structure collée 100. La surchauffe locale en région centrale C agit comme un initiateur de fracture et une séparation précoce s'opère au cours du traitement thermique de fracture, typiquement en fin de rampe (étape 5 de la séquence ci-dessus).

La qualité de surface 10a de la couche mince 10 transférée est améliorée par rapport à une structure SOI obtenue à partir d'une structure collée traitée par un procédé classique, car elle ne présente pas ou très peu de marbrures M ou zones denses ZD. Le niveau de microrugosité (« haze ») de la face d'une couche mince 10 après lissage est également inférieur au niveau de rugosité obtenu par un procédé classique.

Bien sûr, l'invention n'est pas limitée aux modes de réalisation décrits et on peut y apporter des variantes de réalisation sans sortir du cadre de l'invention tel que défini par les revendications.

## Revendications

1. Procédé de transfert d'une couche mince (10) sur un substrat support (2), comprenant les étapes suivantes :
- la fourniture d'une structure collée (100) comportant un substrat donneur (1) et le substrat support (2), assemblés par collage direct au niveau de leurs faces avant (1a,2a) respectives, suivant une interface de collage (3), le substrat donneur (1) comprenant un plan fragile enterré (11),
- l'application d'un traitement thermique de fracture à la structure collée (100) pour induire une séparation spontanée le long du plan fragile enterré (11), liée à une croissance de microfissures dans ledit plan (11) par activation thermique, la séparation menant au transfert d'une couche mince (10) issue du substrat donneur (1) sur le substrat support (2), le traitement thermique de fracture présentant :
- une rampe de montée en température supérieure à 1°C/s, au moins entre une température initiale, inférieure à 250°C, et une température de palier, supérieure ou égale à 500°C, et **caractérisé en ce que** le traitement thermique de fracture présente
- un profil en température tel que la structure collée (100) subisse un gradient de température variant entre 40°C et 120°C entre une région centrale et une région périphérique.

2. Procédé de transfert selon la revendication précédente, comprenant, avant le traitement thermique de fracture, un pré-recuit appliqué à la structure collée (100), de manière à réaliser un pré-murissement des microfissures dans le plan fragile enterré (11), le budget thermique apporté par le pré-recuit étant insuffisant pour provoquer une séparation spontanée.

3. Procédé de transfert selon l'une des revendications précédentes, dans lequel le gradient de température est compris entre 40°C et 80°C.

4. Procédé de transfert selon l'une des revendications précédentes, comprenant une étape de lissage d'une face avant (10a) de la couche mince (10), à la suite de la séparation, par application d'un recuit à une température supérieure à 1000°C, dans une atmosphère neutre ou réductrice, le traitement thermique de fracture et l'étape de lissage s'opérant dans une même enceinte et un même équipement.

5. Procédé de transfert selon l'une des revendications précédentes, dans lequel le plan fragile enterré (11) est formé dans le substrat donneur (1) par implantation d'espèces légères telles que l'hydrogène, l'hélium ou une combinaison de ces deux espèces.

6. Procédé de transfert selon l'une des revendications précédentes, dans lequel le substrat donneur (1) et/ou le substrat support (2) présentent une couche isolante, au moins du côté de leur face avant respective (1a,2a), qui forme une couche isolante enterrée, adjacente à l'interface de collage (3), dans la structure collée (100).

7. Procédé de transfert selon l'une des revendications précédentes, dans lequel la couche mince (10), issue du substrat donneur (1), est en silicium monocristallin et le substrat support (2) comprend du silicium monocristallin, pour former une structure empilée (110) de type SOI.

## Patentansprüche

1. Verfahren zum Übertragen einer dünnen Schicht (10) auf ein Trägersubstrat (2), umfassend die folgenden Schritte:
- Bereitstellen einer geklebten Struktur (100) umfassend ein Donorsubstrat (1) und ein Trägersubstrat (2), die durch direktes Kleben an ihren jeweiligen Vorderseiten (1a, 2a) entlang einer Klebefläche (3) miteinander verbunden sind, wobei das Donorsubstrat (1) eine vergrabene Sprödigkeitsebene (11) umfasst,
- Anwenden einer thermischen Bruchbehandlung auf die geklebte Struktur (100), um eine spontane Trennung entlang der vergrabenen Sprödigkeitsebene (11) zu induzieren, die mit einem Wachstum von Mikrorissen in dieser Ebene (11) durch thermische Aktivierung verbunden ist, wobei die Trennung zur Übertragung einer dünnen Schicht (10) vom Donorsubstrat (1) auf das Trägersubstrat (2) führt, wobei die thermische Bruchbehandlung Folgendes aufweist:
- eine Temperaturanstiegsrate von mehr als 1 °C pro Sekunde, zumindest zwischen einer Anfangstemperatur von weniger als 250 °C und einer Plateau-Temperatur von mehr als oder gleich 500 °C, und **dadurch gekennzeichnet, dass** die thermische Bruchbehandlung
- ein Temperaturprofil aufweist, bei dem die geklebte Struktur (100) einem Temperaturgradienten zwischen 40 °C und 120 °C zwischen einem zentralen Bereich und einem peripheren Bereich ausgesetzt ist.

2. Verfahren zum Übertragen nach dem vorstehenden Anspruch, umfassend, vor der thermischen Bruchbehandlung, eines Vortemperns, das auf die geklebte Struktur (100) angewendet wird, um eine Vorreifung der Mikrorisse in der vergrabenen Sprödigkeitsebene (11) zu erreichen, wobei das durch das Vortempern bereitgestellte thermische Budget nicht ausreicht, um eine spontane Trennung herbeizuführen.

3. Verfahren zum Übertragen nach einem der vorstehenden Ansprüche, wobei der Temperaturgradient zwischen 40 °C und 80 °C liegt.

4. Verfahren zum Übertragen nach einem der vorstehenden Ansprüche, umfassend einen Schritt zum Glätten einer Vorderseite (10a) der dünnen Schicht (10) nach der Trennung durch Anwenden eines Temperns bei einer Temperatur von mehr als 1000 °C in einer neutralen oder reduzierenden Atmosphäre, wobei die Wärmebehandlung des Bruchs und der Glättungsschritt in derselben Umgebung und derselben Anlage durchgeführt werden.

5. Verfahren zum Übertragen nach einem der vorstehenden Ansprüche, wobei die vergrabene Sprödigkeitsebene (11) durch Implantation leichter Spezies wie Wasserstoff, Helium oder einer Kombination dieser beiden Spezies in das Donorsubstrat (1) gebildet wird.

6. Verfahren zum Übertragen nach einem der vorstehenden Ansprüche, wobei das Donorsubstrat (1) und/oder das Trägersubstrat (2) eine Isolierschicht aufweisen, die zumindest auf der Seite ihrer jeweiligen Vorderseite (1a, 2a) angeordnet ist und eine vergrabene Isolierschicht bildet, die an die Klebefläche (3) der geklebten Struktur (100) angrenzt.

7. Verfahren zum Übertragen nach einem der vorstehenden Ansprüche, wobei die dünne Schicht (10), die aus dem Donorsubstrat (1) stammt, aus monokristallinem Silizium besteht und das Trägersubstrat (2) monokristallines Silizium umfasst, um eine gestapelte Struktur (110) vom Typ SOI zu bilden.

## Claims

1. A method for transferring a thin layer (10) onto a carrier substrate (2), comprising the following steps:
- providing a bonded structure (100) comprising a donor substrate (1) and the carrier substrate (2), assembled by direct bonding at the respective front faces (1a, 2a) thereof, along a bonding interface (3), the donor substrate (1) comprising an embedded fragile plane (11),
- applying a fracture heat treatment to the bonded structure (100) to induce spontaneous separation along the embedded fragile plane (11), associated with the growth of microcracks in said plane (11) through thermal activation, the separation leading to the transfer of a thin layer (10) from the donor substrate (1) onto the carrier substrate (2), the fracture heat treatment having:
- a temperature-rise rate in excess of 1°C/s, at least between an initial temperature lower than 250°C and a level temperature higher than or equal to 500°C, and **characterised in that** the fracture heat treatment has
- a temperature profile such that the bonded structure (100) is subjected to a temperature gradient varying between 40°C and 120°C between a central region and a peripheral region.

2. The transfer method according to the preceding claim, comprising, before the fracture heat treatment, a pre-annealing applied to the bonded structure (100), so as to pre-cure the microcracks in the embedded fragile plane (11), the thermal budget imparted by the pre-annealing being insufficient to cause a spontaneous separation.

3. The transfer method according to one of the preceding claims, wherein the temperature gradient is between 40°C and 80°C.

4. The transfer method according to one of the preceding claims, comprising a step of smoothing a front face (10a) of the thin layer (10), following separation, by application of an annealing at a temperature higher than 1,000°C, in a neutral or reductive atmosphere, the fracture heat treatment and the smoothing step being performed in one same chamber and one same piece of equipment.

5. The transfer method according to one of the preceding claims, wherein the embedded fragile plane (11) is formed in the donor substrate (1) by implanting light species such as hydrogen, helium or a combination of these two species.

6. The transfer method according to one of the preceding claims, wherein the donor substrate (1) and/or the carrier substrate (2) have an insulating layer, at least on the side of the respective front face (1a, 2a) thereof, which forms an embedded insulating layer, adjacent to the bonding interface (3), in the bonded structure (100).

7. The transfer method according to one of the preceding claims, wherein the thin layer (10) from the donor substrate (1) is made of monocrystalline silicon and the carrier substrate (2) comprises a monocrystalline silicon, to form an SOI-type stacked structure (110).
